# EUROPEAN PATENT APPLICATION

(11) **EP 4 604 709 A1**
(43) Date of publication of application: **20.08.2025**
(21) Application number: 24210442.0
(22) Date of filing: 03.11.2024
(51) Int. Cl.: H10N 50/80, H10N 50/10, G11C 11/16

(54) **SPIN-ORBIT TORQUE-BASED MAGNETIC TUNNEL JUNCTION**

(30) Priority: 14.02.2024 KR 20240021247
(71) Applicant: Korea University Research and Business Foundation, Seoul 02841 (KR); UNIVERSITY OF ULSAN FOUNDATION FOR INDUSTRY COOPERATION, Nam-gu Ulsan 44610 (KR)
(72) Inventor: KIM, Young Keun, 06009 Seoul (KR); LEE, Ji Young, 13014 Hanam-si (KR); RHIM, Sung Hyon, 44609 Ulsan (KR); NGUYEN, Thi Quynh Anh, 44617 Ulsan (KR)
(74) Representative: Prüfer & Partner mbB Patentanwälte · Rechtsanwälte

(57) **Abstract**

Disclosed is a spin-orbit torque (SOT)-based magnetic tunnel junction, including: a spin-orbit torque active layer formed on a substrate; a magnetization-free layer formed on the spin-orbit torque active layer; a tunnel barrier layer formed on the free magnetic layer; and a magnetization-pinned layer formed on the tunnel barrier layer, wherein the spin-orbit torque active layer is a W-X alloy (where W is tungsten, and X includes at least one of Ti, Zr and Hf or a group III-V semiconductor).

## Description

### CROSS-REFERENCE TO RELATED APPLICATION

This application claims priority to Korean Patent Application No. 10-2024-0021247, filed on February 14, 2024 in the Korean Intellectual Property Office, the disclosure of which is incorporated herein by reference.

### BACKGROUND OF THE DISCLOSURE

### Field of the Disclosure

The present disclosure relates to a spin-orbit torque-based magnetic tunnel junction, and more particularly to a spin-orbit torque-based magnetic tunnel junction that has a structure capable of maintaining perpendicular magnetic anisotropy (PMA) and spin-orbit torque (SOT) switching even after heat treatment after thin film deposition and includes a W-X alloy thin film (where W is tungsten, and X includes at least one of group IV semiconductors and group III-V semiconductors), which has a composition with a high spin-orbit torque efficiency at low resistivity, as a spin-orbit torque active layer.

### Description of the Related Art

A magnetic tunnel junction basically has a triple-layer structure of ferromagnetic substance/oxide/ferromagnetic substance, each of which includes a magnetization-free layer (FL), a tunnel barrier (TB) and a magnetized pinned layer (PL). Here, the positions of the magnetization-free layer and the pinned layer may be interchanged. The magnetic tunnel junction uses the property that the value of a tunneling current passing through the tunnel barrier is changed depending upon the state in which the spin direction of the adjacent magnetization-free layer and pinned layer are arranged in parallel or antiparallel with the tunnel barrier interposed therebetween. A resistance difference at this point is called a tunnel magnetoresistance ratio (TMR). The spin direction of the pinned layer is fixed, and information can be input by flowing a magnetic field or current to manipulate the spin direction of the magnetization-free layer.

A magnetic tunnel junction (MTJ) structure, which is a core element of spin-orbit torque (SOT) switching-based magnetic random access memory (MRAM) as an existing technology, may be composed of a non-magnetic spin-orbit torque active layer (hereinafter referred to as "spin-orbit torque active layer")/a first magnetic layer (magnetization-free layer)/a tunnel barrier layer/a second magnetic layer (magnetization-pinned layer).

The MTJ structure reads information using the tunneling magnetoresistance (TMR) phenomenon that an electrical resistance value of a tunneling current passing through an insulating layer changes depending on the relative magnetization directions of the magnetization-free layer and the pinned layer.

To realize a high tunnel magnetoresistance ratio, high write stability, low write current and high integration, a magnetic tunnel junction must have the perpendicular magnetic anisotropy (PMA) property. PMA means that the magnetization direction of a magnetic layer is perpendicular to a magnetic layer plane.

Recently, the spin-orbit torque (SOT) phenomenon that induces switching of a magnetization-free layer using the spin Hall effect or the Rashba effect occurring when current flows in a parallel direction in a plane of a spin-orbit active layer adjacent to the magnetization-free layer was found. Accordingly, SOT is attracting attention as a technology capable of writing information at higher speed and lower current consumption than an existing spin-transfer torque (STT) writing method.

An essential design criteria for spin-orbit torque devices are to form a spin-torque active layer using a material structure that has a low resistivity, and a large spin Hall angle (SHA) as a physical quantity (unitless) that indicates the efficiency of spin-orbit torque.

With regard to this, US Patent No. 11062752 (hereinafter referred to as '752 Patent') discloses a SOT magnetic tunnel junction structure based on W or Ta. In addition, Physical Review B 98, 134411(2018), "Temperature study of the giant spin Hall effect in the bulk limit of β-W" (hereinafter referred to as the "prior paper") discloses that the efficiency of SOT is increased even when W is thick by changing the W deposition technique to maintain high resistivity when producing a thin film with a W/CoFeB/MgO structure.

However, the '752 Patent' and the 'prior paper' do not disclose maintaining the perpendicular magnetic anisotropy in an alloy thin film structure and increasing the efficiency of SOT at low resistivity.

### [Related Art Documents]

### [Patent Document]

US Patent NO. 11062752 (registered on July 13, 2021)

### [Non-Patent Document]

Physical Review B 98, 134411(2018), "Temperature study of the giant spin Hall effect in the bulk limit of β-W"

### SUMMARY OF THE DISCLOSURE

Therefore, the present disclosure has been made in view of the above problems, and it is an object of the present disclosure to provide a spin-orbit torque-based magnetic tunnel junction including a W-X alloy thin film (where W is tungsten, and X includes at least one of group IV semiconductors and group III-V semiconductors) having large spin-orbit coupling as a spin-orbit torque active layer. A device having the spin-orbit torque-based magnetic tunnel junction applied thereto enables spin-orbit torque switching and can exhibit high spin-orbit torque efficiency at low resistivity.

It is still another object of the present disclosure to provide a spin-orbit torque-based magnetic tunnel junction including a W-X alloy in which the composition of X may be adjusted to control a switching current, and a method of manufacturing the spin-orbit torque-based magnetic tunnel junction.

It is still another object of the present disclosure to provide a spin-orbit torque-based magnetic tunnel junction allowing the maintenance of perpendicular magnetic anisotropy (PMA) even after heat treatment because it includes a tungsten-titanium alloy as a spin-orbit torque active layer.

It is still another object of the present disclosure to maintain PMA by using a tungsten-titanium alloy layer as a conductor layer that provides an in-plane current by contacting a magnetization-free layer, to enhance the spin-orbit torque effect of SOT-MRAM and to reduce an operating current.

It is still another object of the present disclosure to provide a material composition range in which PMA is expressed when a tungsten-titanium alloy layer is used as a material for MRAM.

It is still another object of the present disclosure to provide heat treatment conditions in which PMA is expressed when a tungsten-titanium alloy layer is used as a material for MRAM.

It is yet another object of the present disclosure to provide resistivity and SOT efficiency dependent upon heat treatment conditions when a tungsten-titanium alloy layer is used as a material for MRAM.

It will be understood that technical problems of the present disclosure are not limited to the aforementioned problems and other technical problems not referred to herein will be clearly understood by those skilled in the art from disclosures below.

In accordance with an aspect of the present disclosure, the above and other objects can be accomplished by the provision of a spin-orbit torque-based magnetic tunnel junction, including: a spin-orbit torque active layer formed on a substrate; a magnetization-free layer formed on the spin-orbit torque active layer; a tunnel barrier layer formed on the magnetization-free layer; and a magnetization-pinned layer formed on the tunnel barrier layer, wherein the spin-orbit torque active layer is a W-X alloy (where W is tungsten, and X includes at least one of group IV semiconductors and group III-V semiconductors).

The spin-orbit torque active layer may be an electrode that provides an in-plane current by contacting the magnetization-free layer.

A switching current may be decreased with increasing composition content of X contained in the W-X alloy.

The W-X alloy may be a tungsten-titanium (W-Ti) alloy in which a composition content of titanium is 11.5 at% to 20.8 at%.

A heat treatment temperature at which perpendicular magnetic anisotropy is expressed may be 300 °C.

A composition content of X contained in the W-X alloy may be controlled depending upon a heat treatment temperature at which perpendicular magnetic anisotropy is expressed.

The spin-orbit torque active layer may have a cross shape when viewed in a planar plane, and the magnetization-free layer, the tunnel barrier layer and the pinned layer may be arranged in an island shape at a center of the cross-shaped spin-orbit torque active layer.

A surface of the substrate in contact with the spin-orbit torque active layer may include a natural oxide layer.

A lower side of the spin-orbit torque active layer may further include a buffer layer.

A capping layer may be further included on the magnetization-pinned layer.

A method of manufacturing a spin-orbit torque-based magnetic tunnel junction according to an embodiment of the present disclosure includes: forming a spin-orbit torque active layer on a substrate; forming a magnetization-free layer on the spin-orbit torque active layer; forming a tunnel barrier layer on the magnetization-free layer; forming a magnetization-pinned layer on the tunnel barrier layer; and heat-treating the magnetization-free layer and the magnetization-pinned layer to express perpendicular magnetic anisotropy, wherein in the forming of the spin-orbit torque active layer on the substrate, a W target and an X target are simultaneously sputtered in a vacuum chamber so that a W-X alloy thin film (where W is tungsten and X includes at least one of group IV semiconductors and group III-V semiconductors) is formed on the substrate placed in the vacuum chamber.

The X target may be a titanium (Ti) target, and the composition of the tungsten-titanium alloy thin film may be controlled depending on the power of the tungsten target and the titanium target.

A composition content of X included in the W-X alloy may be 11.5 at% to 20.8 at%.

In the spin-orbit torque-based magnetic tunnel junction, the heat treatment temperature at which PMA is expressed may be 300 °C.

A composition content of X contained in the W-X alloy may be controlled depending upon the heat treatment temperature at which PMA is expressed.

The forming of the spin-orbit torque active layer on the substrate may further include patterning the tungsten-titanium alloy thin film in a cross shape.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 illustrates a sectional view of a spin-orbit torque-based magnetic tunnel junction according to an embodiment of the present disclosure;
FIG. 2 illustrates a plan view of the spin-orbit torque-based magnetic tunnel junction according to an embodiment of the present disclosure;
FIG. 3 is a flowchart illustrating a method of manufacturing the spin-orbit torque-based magnetic tunnel junction according to an embodiment of the present disclosure;
FIG. 4 illustrates results of the phase stability and spin Hall conductivity values for each W-Ti composition obtained by first-principle energy band calculation;
FIG. 5 illustrates a sectional view of a structure for measuring the spin-orbit torque efficiency of the spin-orbit torque-based magnetic tunnel junction according to an embodiment of the present disclosure;
FIG. 6 is a graph illustrating the quantitative analysis of the composition of Ti by Rutherford Backscattering Spectrometry (RBS);
FIG. 7 illustrates magnetic hysteresis loops (VSM), measured by a vibrating sample magnetometer, for thin films after a heat treatment at 300 °C;
FIG. 8 illustrates the spin Hall angle of a Hall bar-shaped device measured using a harmonics measurement method in the composition range of a tungsten-titanium alloy layer having perpendicular magnetic anisotropy (PMA) after heat-treating a W-Ti 5/CoFeB 0.9/MgO 1.0/ Ta 2 (unit: nm) structure at 300 °C; and the spin Hall conductivity converted from the spin Hall angle;
FIG. 9 illustrates the resistivity of an alloy layer measured using a four-point probe in the composition range of a tungsten-titanium alloy layer having PMA after heat-treating a W-Ti 5/CoFeB 0.9/MgO 1.0/ Ta 2(unit: nm) structure at 300 °C;
FIG. 10 illustrates the spin-orbit torque switching characteristics dependent upon the composition of a tungsten-titanium alloy layer when an external magnetic field of ±300 Oe is applied to a specimen having a W-Ti 5/CoFeB 0.9/MgO 1.0/Ta 2 (unit: nm) structure that has been heat-treated at 300 °C;
FIG. 11 illustrates a change in switching current density when an external magnetic field of ±300 Oe is applied to a specimen having a W-Ti 5/CoFeB 0.9/MgO 1.0/Ta 2 (unit: nm) structure that has been heat-treated at 300 °C;
FIG. 12 illustrates switching current (current density) measurement results measured while changing the magnitude of an external magnetic field after a specimen having a W-Ti 5/CoFeB 0.9/MgO 1.0/Ta 2 (unit: nm) structure and containing titanium, which formed a tungsten-titanium alloy layer, in a content of 11.5 at% was heat-treated at 300 °C;
FIG. 13 illustrates a change in the switching current density of a device, to which a spin-orbit torque-based magnetic tunnel junction is applied, according to the conversion of an operating temperature;
FIG. 14 illustrates a normalized resistance change in a device, to which the spin-orbit torque-based magnetic tunnel junction was applied, measured by switching 100 times at extreme temperatures of (a) -55 °C and (b) 150 °C to verify the operating temperature stability of the device; and
FIG. 15 illustrates a change in the current density (switching current density, Jc) of a device, to which the spin-orbit torque-based magnetic tunnel junction was applied, dependent upon an operating temperature and an external magnetic field.

### DETAILED DESCRIPTION OF THE DISCLOSURE

Specific structural and functional descriptions of embodiments according to the concept of the present disclosure disclosed herein are merely illustrative for the purpose of explaining the embodiments according to the concept of the present disclosure. Furthermore, the embodiments according to the concept of the present disclosure can be implemented in various forms and the present disclosure is not limited to the embodiments described herein.

The embodiments according to the concept of the present disclosure may be implemented in various forms as various modifications may be made. The embodiments will be described in detail herein with reference to the drawings. However, it should be understood that the present disclosure is not limited to the embodiments according to the concept of the present disclosure, but includes changes, equivalents, or alternatives falling within the spirit and scope of the present disclosure.

The terms such as "first" and "second" are used herein merely to describe a variety of constituent elements, but the constituent elements are not limited by the terms. The terms are used only for the purpose of distinguishing one constituent element from another constituent element. For example, a first element may be termed a second element and a second element may be termed a first element without departing from the scope of rights according to the concept of the present disclosure.

It will be understood that when an element is referred to as being "on", "connected to" or "coupled to" another element, it may be directly on, connected or coupled to the other element or intervening elements may be present. In contrast, when an element is referred to as being "directly on," "directly connected to" or "directly coupled to" another element or layer, there are no intervening elements or layers present. Other words used to describe the relationship between elements should be interpreted in a like fashion (e.g., "between," versus "directly between," "adjacent," versus "directly adjacent," etc.).

The terms used in the present specification are used to explain a specific exemplary embodiment and not to limit the present inventive concept. Thus, the expression of singularity in the present specification includes the expression of plurality unless clearly specified otherwise in context. Also, terms such as "include" or "comprise" in the specification should be construed as denoting that a certain characteristic, number, step, operation, constituent element, component or a combination thereof exists and not as excluding the existence of or a possibility of an addition of one or more other characteristics, numbers, steps, operations, constituent elements, components or combinations thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present disclosure is described in more detail with reference to the accompanying drawings illustrating embodiments of the present disclosure.

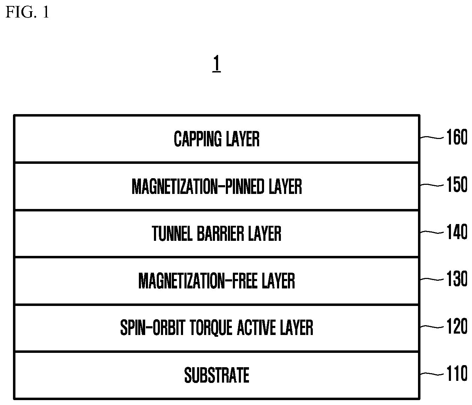

FIG. 1 illustrates a sectional view of a spin-orbit torque-based magnetic tunnel junction 1 according to an embodiment of the present disclosure.

As shown in FIG. 1, the spin-orbit torque (SOT)-based magnetic tunnel junction according to an embodiment of the present disclosure includes a spin-orbit torque active layer 120 formed on a substrate 110, a magnetization-free layer 130 formed on the spin-orbit torque active layer 120, a tunnel barrier layer 140 formed on the magnetization-free layer 130 and a magnetization-pinned layer 150 formed on the tunnel barrier layer 140, wherein the spin-orbit torque active layer 120 includes a W-X alloy (where W is tungsten and X includes at least one of group IV semiconductors and group III-V semiconductors).

Accordingly, the spin-orbit torque-based magnetic tunnel junction 1 according to an embodiment of the present disclosure may enable spin-orbit torque switching and may have a high spin-orbit torque efficiency at low resistivity by using a W-X alloy having large spin-orbit coupling as the spin-orbit torque active layer 120.

The spin-orbit torque-based magnetic tunnel junction according to an embodiment of the present disclosure includes the spin-orbit torque active layer 120 formed on the substrate 110.

The substrate 110 may include a semiconductor substrate. The semiconductor substrate may include silicon (Si), silicon-on-insulator (SOI), silicon germanium (SiGe), germanium (Ge), gallium arsenide (GaAs), etc.

A surface, which is contact with the spin-orbit active layer 120, of the substrate 110 may include a native oxide layer. The native oxide layer formed on a surface of the substrate 110 may be amorphous.

According to an embodiment, at least one of a seed layer and a buffer layer may be further included on the substrate 110.

Accordingly, the seed layer and the buffer layer may be formed between the substrate 110 and the spin-orbit active layer 120.

The seed layer may be formed on the substrate 110 and on the spin-orbit active layer 120. The seed layer is a material that enables crystal growth and allows a magnetic material to grow in a desired crystal direction.

The seed layer may include at least one of tantalum (Ta), ruthenium (Ru), titanium (Ti), palladium (Pd), platinum (Pt), magnesium (Mg), cobalt (Co), aluminum (Al) and tungsten (W), but is not limited thereto. Preferably, the seed layer may be a Ta layer having a thickness of 5 nm.

The buffer layer may be formed under the spin-orbit active layer 120. The buffer layer formed under the spin-orbit active layer 120 may increase the crystallinity of the spin-orbit active layer 120.

In addition, the buffer layer may be provided to resolve lattice constant mismatch among layers.

In addition, the seed layer and the buffer layer may be formed as a single layer without being separated from each other. For example, the buffer layer may also function as a seed layer.

The buffer layer may include at least one of Ta, W and Pd, but is not limited thereto. Preferably, the buffer layer may be a Pd layer having a thickness of 10 nm or a Ta layer having a thickness of 2 nm.

The spin-orbit active layer 120 may be brought into contact with the magnetization-free layer 130, thereby being used as an electrode to provide in-plane current, and may provide in-plane current, thereby causing the spin Hall effect or the Rashba effect.

The spin-orbit active layer 120 may provide spin-polarized current and may induce the magnetic reversal of the magnetization-free layer 130 by applying spin-orbit torque to the magnetization-free layer 130 due to the spin Hall effect or the Rashba effect of the spin-orbit active layer 120. In addition, the spin-orbit active layer 120 may provide the magnetization-free layer 130 with spin accumulation aligned in a magnetization direction of the spin-orbit active layer 120. Here, the spin accumulation may provide a deterministic switching effect or additional torque.

In addition, current driven in a plane through the spin-orbit active layer 120 and the accompanying spin-orbit interactions may cause a spin-orbit magnetic field (H). The spin-orbit magnetic field (H) is equal to spin-orbit torque (T) on magnetization. Accordingly, torque and a magnetic field may be interchangeably referred to as a spin-orbit magnetic field and spin-orbit torque. This reflects the fact that a spin-orbit interaction is the source of spin-orbit torque and a spin-orbit magnetic field. Spin-orbit torque may be generated by current and a spin-orbit interaction driven in the plane of the spin-orbit active layer 120.

The spin-orbit active layer 120 may be an electrode that has a strong spin-orbit interaction and is used during magnetic moment switching of the magnetization-free layer 130.

In addition, the spin-orbit active layer 120 may facilitate switching of a magnetic field in the magnetization-free layer 130, and the spin-orbit active layer 120 may change a polarity direction of the magnetic field in the magnetization-free layer 130 to implement a spin transfer torque memory.

Accordingly, the spin-orbit torque-based magnetic tunnel junction 1 according to an embodiment of the present disclosure may use spin-orbit torque (SOT) to switch the magnetization-free layer 130 using spin current to operate an MRAM memory cell.

The spin-orbit torque-based magnetic tunnel junction 1 according to an embodiment of the present disclosure may use a W-X alloy (where W is tungsten and X includes at least one of group IV semiconductors and group III-V semiconductors) as the spin-orbit active layer 120. Accordingly, perpendicular magnetic anisotropy (PMA) may be maintained in various heat treatment temperature ranges.

Preferably, the group IV semiconductor may include at least one of titanium (Ti), zirconium (Zr), hafnium (Hf), and an alloy thereof, and the group III-V semiconductor may include at least one of GaAs, GaP, InP, InGaAlN and GaN, without being limited thereto. Preferably, the spin-orbit torque-based magnetic tunnel junction according to an embodiment of the present disclosure may use a tungsten (W)-titanium (Ti) alloy as the spin-orbit torque active layer 120.

More particularly, the spin-orbit torque (SOT) is represented by the spin Hall effect and the Rashba effect caused by spin orbital interaction. Such a phenomenon may strongly appear in proportion to the atomic number. Accordingly, studies focusing on heavy metal materials (W, Ta, Pt, etc.) have been conducted, and studies, such as alloying or insertion of various materials, to further improve the properties and efficiency of a single heavy metal material are being conducted.

Accordingly, from the spintronics view point, tungsten has strong spin-Hall effect due to the spin-orbit interaction because tungsten is a material with excellent spin-orbit torque (SOT) expression, making it easy to use as a SOT-MRAM material. In addition, the spin Hall effect and the Rashba effect which are known as the cause of the spin-orbit torque are present in X (group IV such as Ti, Ge, groups III-V such as Ga-As, etc.) semiconductor materials. Accordingly, spin-orbit torque switching is possible and high spin-orbit torque efficiency may be achieved even at low specific resistance when a WX alloy is used as the spin-orbit active layer 120.

Preferably, a W-Ti alloy may be used as the spin-orbit active layer 120 because tungsten (W) and titanium (Ti) are essential materials for a semiconductor process and, a W-Ti alloy is also a very suitable material for a semiconductor process due to low contact resistance when thermally treated at high temperature.

The X element included in the spin-orbit active layer 120 of the spin-orbit torque-based magnetic tunnel junction according to an embodiment of the present disclosure is a semiconductor material and may exhibit extrinsic spin Hall effect.

Accordingly, as the content of X (e.g., titanium) in tungsten increases due to the extrinsic spin Hall effect of X which is partially present as an impurity inside tungsten, Spin Hall angle called the spin-orbit torque efficiency may increase

In addition, as electron scattering increases due to X partially present as an impurity inside tungsten, and thus, the content of X in tungsten increases, the specific resistance of a W-X alloy thin film may increase.

Switching current of the spin-orbit torque-based magnetic tunnel junction according to an embodiment of the present disclosure may be decreased as the content of X included in a W-X alloy increases.

In addition, the content of X included in the W-X alloy may be 11.5 at% to 20.8 at%. However, the content of X in the W-X alloy is not limited to the range and may be controlled depending upon the type of X.

As the content of X in the W-X alloy increases, PMA may be weakened. In addition, when the content of X in the W-X alloy is outside a specific content (e.g., 46.4 at%) range, PMA may be lost.

Preferably, the composition of X in the W-X alloy may be controlled according to a heat treatment temperature. When the heat treatment temperature is 300 °C and the composition of X is 0.1 at% to 46.4 at%, PMA may be expressed. However, the content of X in the W-X alloy according to a heat treatment temperature is not limited to the ranges, and may be adjusted depending upon the type of X.

When the content of X in the W-X alloy is less than 11.5 at%, this is the same as the case of composed of 100 at% of tungsten, which corresponds to an existing tungsten-based spin-orbit torque material excluding X. Accordingly, a spin-orbit torque efficiency may be decreased.

When the heat treatment temperature is 300 °C and the content of X in the W-X alloy exceeds 46.4 at%, PMA may be lost, and the magnetic properties of magnetic layers (magnetization-free layer and a magnetization-pinned layer) formed on a W-X alloy thin film may be lost. Accordingly, it may not be used as a magnetic tunnel junction element.

For example, when a tungsten (W)-titanium (Ti) alloy is used as the spin-orbit torque active layer 120, a titanium composition ratio (x, where x is a real number) in which PMA is expressed may satisfy 0.1 at% ≤ x ≤ 46.4 at% when a heat treatment temperature is 300 °C.

The switching current of the spin-orbit torque-based magnetic tunnel junction according to an embodiment of the present disclosure may be decreased as a heat treatment temperature at which PMA is expressed increases.

The heat treatment temperature at which PMA is expressed may be 300 °C.

Since a Back End Of Line (BEOL) process included in a semiconductor device process includes heat treatment at 300 °C to 400 °C, it is essential to develop an element capable of maintaining magnetic properties at such temperature.

Accordingly, since the spin-orbit torque-based magnetic tunnel junction 1 having a CoFeB/MgO (free layer/tunnel barrier layer) structure according to an embodiment of the present disclosure should be thermally treated at at least 250 °C to 300 °C for PMA expression such that the crystallization of CoFeB (magnetization-free layer) proceeds, heat treatment should be performed at 300 °C or higher. When the heat treatment temperature is higher than 500 °C, the temperature is outside a temperature range in which CoFeB (magnetization-free layer) utilized as a magnetic layer can withstand, so that the properties of the magnetic layer are lost.

The spin torque efficiency of the spin-orbit torque-based magnetic tunnel junction according to an embodiment of the present disclosure may be adjusted depending upon the thickness of the spin-orbit active layer 120. As the thickness of the spin-orbit active layer 120 increases from 1 nm, the spin torque efficiency increases and then is saturated. Accordingly, when the thickness of the spin-orbit active layer 120 is 5 nm to 7 nm, the maximum spin torque efficiency may be exhibited.

Preferably, since W may have an optimal thickness at 5 nm so as to maintain a beta phase having high spin torque efficiency, the spin-orbit active layer 120 may have a thickness of 5 nm.

The spin-orbit torque-based magnetic tunnel junction according to an embodiment of the present disclosure includes the magnetization-free layer 130 to be formed on the spin-orbit active layer 120.

The magnetization of the magnetization-free layer 130 may be changed from one direction to a direction opposite thereto without being fixed to one direction. The magnetization-free layer 130 may have the same magnetization direction (i.e., parallel direction) as the magnetization-pinned layer 150 or an opposite magnetization direction (i.e., antiparallel direction) thereto.

The magnetic tunnel junction may be used as a memory device by matching information to resistance values that change according to the magnetization arrangement of the magnetization-free layer 130 and the magnetization-pinned layer 150.

For example, when the magnetization direction of the magnetization-free layer 130 is parallel to that of the magnetization-pinned layer 150, the resistance value of the magnetic tunnel junction is decreased. This case may be defined as data '0'. In addition, when the magnetization direction of the magnetization-free layer 130 is antiparallel to that of the magnetization-pinned layer 150, the resistance value of the magnetic tunnel junction increases. This case may be defined as data '1'.

In the spin-orbit torque-based magnetic tunnel junction according to an embodiment of the present disclosure, the magnetization-free layer 130 may have PMA.

For example, when the magnetization direction of the magnetization-free layer 130 is a negative z-axis direction, the rotation direction of current may be clockwise so as to reverse the magnetization in a positive z-axis direction. The torque caused by in-plane current and applied to the magnetic moment of the magnetization-free layer 130 may be referred to as spin-orbit torque.

The magnetization-free layer 130 may include a material having interface perpendicular magnetic anisotropy (PMA). Interface PMA refers to a phenomenon wherein a magnetic layer having intrinsic horizontal magnetization characteristics has a perpendicular magnetization direction due to influence from an interface between another layer adjacent thereto. The magnetization-free layer 130 may include at least one of cobalt (Co), iron (Fe), and nickel (Ni).

In addition, the magnetization-free layer 130 may further include at least one of non-magnetic materials such as boron (B), zinc (Zn), aluminum (Al), titanium (Ti), ruthenium (Ru), tantalum (Ta), silicon (Si), silver (Ag), gold (Au), copper (Cu), carbon (C), and nitrogen (N).

For example, the magnetization-free layer 130 may include CoFe or NiFe, and may further include boron (B). Additionally, a reference layer 126 and the magnetization-free layer 130 may further include at least one of titanium (Ti), aluminum (Al), silicon (Si), magnesium (Mg), tantalum (Ta) and silicon (Si).

According to an embodiment, the magnetization-free layer 130 may include at least one of materials having an L10 crystal structure, materials having a hexagonal close-packed lattice (HCP), and amorphous rare-earth transition metal (RE-TM) alloys.

To express perpendicular magnetic anisotropy, the thickness of the magnetization-free layer 130 may be 0.8 to 1 nm, preferably 0.9 nm, but is not limited thereto.

The spin-orbit torque-based magnetic tunnel junction 1 according to an embodiment of the present disclosure includes the tunnel barrier layer 140 to be formed on the magnetization-free layer 130.

The tunnel barrier layer 140 separates the magnetization-free layer 130 and the pinned layer 160 from each other and enables quantum mechanical tunneling between the magnetization-free layer 130 and the pinned layer 160.

The tunnel barrier layer 140 may be interposed between the magnetization-free layer 130 and the magnetization-pinned layer 150.

The tunnel barrier layer 140 may include at least one of an oxide of magnesium (Mg), an oxide of titanium (Ti), an oxide of aluminum (Al), an oxide of magnesium-zinc (MgZn), an oxide of magnesium-boron (MgB), a nitride of titanium (Ti), and a nitride of vanadium (V). For example, the tunnel barrier layer 140 may include crystalline magnesium oxide (MgO).

To express perpendicular magnetic anisotropy, the thickness of the tunnel barrier layer 140 may be 1.9 to 1.1 nm, preferably 1.0 nm, but is not limited thereto.

The spin-orbit torque-based magnetic tunnel junction according to an embodiment of the present disclosure includes the magnetization-pinned layer 150 to be formed on the tunnel barrier layer 140.

The magnetization-pinned layer 150 may have a fixed magnetic moment during a write operation of a magnetic memory device. For example, the magnetic moment of the magnetization-pinned layer 150 may not be switched due to spin-orbit torque caused by currents flowing through the spin-orbit active layer 120.

The magnetization-pinned layer 150 may include a material having interface perpendicular magnetic anisotropy.

Interface PMA refers to a phenomenon wherein a magnetic layer having intrinsic horizontal magnetization characteristics has a perpendicular magnetization direction due to influence from an interface between the magnetic layer and another layer adjacent thereto. The magnetization-pinned layer 150 may include at least one of cobalt (Co), iron (Fe), and nickel (Ni).

In addition, the magnetization-pinned layer 150 may further include at least one of non-magnetic materials such as boron (B), zinc (Zn), aluminum (Al), titanium (Ti), ruthenium (Ru), tantalum (Ta), silicon (Si), silver (Ag), gold (Au), copper (Cu), carbon (C), and nitrogen (N).

For example, the magnetization-pinned layer 150 may include CoFe or NiFe, and may further include boron (B). In addition, the reference layer 126 and the magnetization-free layer 122 may further include at least one of titanium (Ti), aluminum (Al), silicon (Si), magnesium (Mg), tantalum (Ta) and silicon (Si).

The magnetization-pinned layer 150 may have a single layer structure. According to an embodiment, the magnetization-pinned layer 150 may include a synthetic antiferromagnetic substance having ferromagnetic layers separated by nonmagnetic layer(s).

According to an embodiment, the magnetization-pinned layer 150 may include at least one of materials having an L10 crystal structure, materials having a hexagonal close-packed lattice (HCP), and amorphous RE-TM alloys.

The magnetization-pinned layer 150 may be formed to be thicker than the magnetization-free layer 130 so that switching does not easily occur.

The spin-orbit torque-based magnetic tunnel junction 1 may further include a capping layer 160 to be formed on the magnetization-pinned layer 150. Preferably, Ta may be used in the capping layer 160.

The capping layer 160 may be used as an anti-oxidation layer, and may be deposited to a thickness of 1 to 2.2 nm, preferably, 2 nm, to prevent the properties of magnetic layers (the magnetization-free layer 130 and the magnetization-pinned layer 150) from being reduced by natural oxidation.

When the thickness of the capping layer 160 is thicker than 2.2 nm, anti-oxidation effect may be increased, but the tunnel barrier layer 140 may be affected during deposition of the capping layer 160. Accordingly, perpendicular magnetic anisotropy conditions (the thicknesses of the magnetization-free layer 130 and the tunnel barrier layer 140) should be controlled. When the capping layer 160 is formed in a thickness thinner 1 nm, antioxidant effects may be decreased.

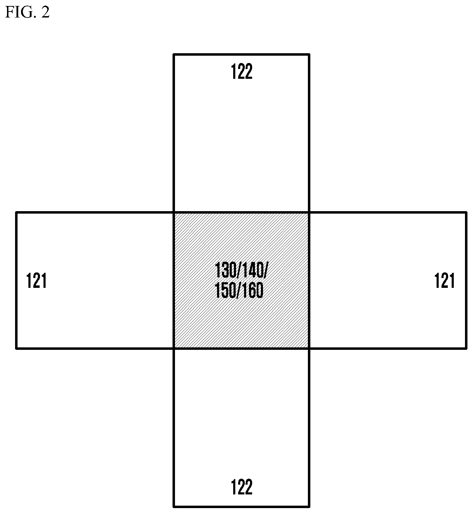

FIG. 2 illustrates a plan view of the spin-orbit torque-based magnetic tunnel junction 1 according to an embodiment of the present disclosure.

In the spin-orbit torque-based magnetic tunnel junction 1 according to an embodiment of the present disclosure, the spin-orbit torque active layer 120, the magnetization-free layer 130, the tunnel barrier layer 140 and the magnetization-pinned layer 150 may have a cross shape when viewed in a planar plane.

In addition, the spin-orbit active layer 120 of the spin-orbit torque-based magnetic tunnel junction 1 according to an embodiment of the present disclosure may have a cross shape in plan view, and the magnetization-free layer 130, the tunnel barrier layer 140 and the magnetization-pinned layer 150 may be disposed in the form of an island in the center of the spin-orbit active layer 120 having a cross shape.

Referring to FIG. 2, the spin-orbit torque-based magnetic tunnel junction 1 according to an embodiment of the present disclosure wherein the spin-orbit active layer 120 has a cross shape in plan view, and the magnetization-free layer 130, the tunnel barrier layer 140 and the magnetization-pinned layer 150 are arranged in the form of an island in the center of the spin-orbit active layer 120 having a cross shape is described in detail.

The spin-orbit torque-based magnetic tunnel junction 1 electrically measures resistance changes according to the magnetization directions of the magnetic layers. When all the layers have a cross shape (the spin-orbit active layer 120, the magnetization-free layer 130, the tunnel barrier layer 140 and the magnetization-pinned layer 150 have a cross shape in plan view), the volume of the magnetic layers increases, and thus, signals are well displayed, which facilitates property analysis.

On the other hand, when the spin-orbit active layer 120 has a cross shape in plan view.

The magnetization-free layer 130, the tunnel barrier layer 140 and the magnetization-pinned layer 150 are arranged in the form of an island in the center of the spin-orbit active layer 120 having a cross shape, this is only utilized upon switching using spin-orbit torque. At this time, the magnetization direction of the magnetization-free layer may be prevented from being changed by domain wall propagation, not spin-orbit torque, and magnetization reversal due to only spin-orbit torque may be observed. In addition, when the magnetization-free layer 130, the tunnel barrier layer 140 and the magnetization-pinned layer 150 are arranged in the form of an island, an etching step should be performed once more after fabricating all the layers in a cross shape. When the spin-orbit active layer 120 begins to be exposed during etching, the etching should be immediately stopped. Accordingly, know-how in device fabrication is required.

The spin-orbit active layer 120 having a cross shape may include a first conductive line 121 and a second conductive line 122. The first conductive line 121 and the second conductive line 122 may be formed to cross each other.

Accordingly, in the magnetization switching method, the magnetization-free layer 130 may perform magnetization reversal by applying a first AC current jx having a first frequency to the first conductive line 121 and applying a second AC current jy having a first frequency to the second conductive line 122.

When a first current having a first angular frequency ω is injected to the first conductive line 121, and a second current having the first angular frequency ω is injected to the second conductive line 122, the total current vector at a position at which the magnetization-free layer 130, the tunnel barrier layer 140 and the magnetization-pinned layer 150 are disposed may rotate with time.

From the point of view of a rotating coordinate system like the phase of the total current vector, AC current turns into a problem of DC current. Meanwhile, from the standpoint of a rotating coordinate system, an effective magnetic field in a vertical direction corresponding to a rotational angular velocity appears. That is, the effect of AC current is converted to a problem of DC current in a system with an effective magnetic field in a vertical direction. In this case, the magnetization of a magnetization-free layer may be very easily reversed due to the effect of the effective magnetic field in a vertical direction.

The first conductive line 121 and the second conductive line 122 may be formed of materials that induce the spin Hall effect or the Rashba effect. When the first current flows in the first conductive line 121, spin polarization perpendicular to a traveling direction of the first conductive line 121 occurs, and spin current travels in the magnetization-free layer direction (z-axis direction).

The first conductive line 121 may have a line shape extending in an x-direction. The second conductive line 122 may have a line shape crossing the first conductive line 121. For example, the second conductive line 122 may have a line shape extending in a y-direction.

The first conductive line 121 and the second conductive line 122 may cross each other at a point and may be connected to each other. For example, the first conductive line 121 and the second conductive line 122 may be positioned in the same plane (i.e., x-y plane).

The spin-orbit torque-based magnetic tunnel junction according to an embodiment of the present disclosure may electrically measure characteristics due to the spin Hall effect by patterning the spin-orbit active layer 120 in a cross shape, and may measure the movement of magnetization by spin torque with voltage in a direction perpendicular to a current injection direction.

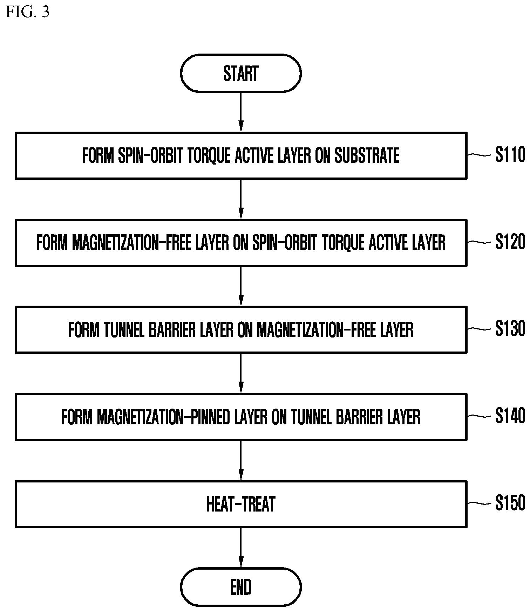

FIG. 3 is a flowchart illustrating a method of manufacturing the spin-orbit torque-based magnetic tunnel junction according to an embodiment of the present disclosure.

Since the method includes the same components as in the spin-orbit torque-based magnetic tunnel junction 1 according to an embodiment of the present disclosure, a description of the same components is omitted.

First, the method of fabricating a spin-orbit torque-based magnetic tunnel junction according to an embodiment of the present disclosure includes a step (S110) of forming a spin-orbit active layer on a substrate.

The substrate may be a silicon substrate, and a native oxide layer may be formed on a surface of the silicon substrate. According to an embodiment, the native oxide layer may be formed by CVD, PVD or thermal oxidation.

According to an embodiment, the method of fabricating a spin-orbit torque-based magnetic tunnel junction according to an embodiment of the present disclosure may include at least one of a step of forming a seed layer on the substrate and a step of forming a buffer layer on the substrate, before formation of the spin-orbit active layer on the substrate.

The seed layer and the buffer layer may be formed by physical vapor deposition (PVD) including sputtering, molecular beam epitaxy (MBE), pulsed laser deposition (PLD), atomic layer deposition (ALD), e-beam epitaxy, chemical vapor deposition (CVD), a derived CVD process such as low-pressure CVD (LPCVD), ultrahigh vacuum CVD (UHVCVD) or reduced pressure CVD (RPCVD), electroplating, coating or any combination thereof. In the step (S110) of forming a spin-orbit active layer on a substrate, W target and X target are simultaneously sputtered in a vacuum chamber to form a W-X alloy (where W is tungsten and X includes at least one of a group IV semiconductor and a group III-V semiconductor) thin film on a substrate disposed in the vacuum chamber.

Preferably, a tungsten-titanium alloy thin film may be formed on the substrate disposed in the vacuum chamber by co-deposition of simultaneously sputtering W target and X target in a vacuum chamber.

By the method of fabricating a spin-orbit torque-based magnetic tunnel junction according to an embodiment of the present disclosure, the composition of a W-X alloy thin film may be controlled according to the power and thickness of W target and X target.

First, the composition of the W-X alloy thin film may be adjusted according to the power of W target and X target.

The power of W target may be 0.1 W to 85 W (0 W/cm² to 4.19 W/cm²). When the power of W target is less than 0.1 W, there is a problem that W is not deposited. When the power of W target is greater than 85 W, there is a problem that cracks are generated due to too high energy applied to W target.

The power of X target may be 0.1 W to 86.2 W (0.1 W/cm² to 4.25 W/cm²). When the power of X target is less than 0.1 W, there is a problem that X is not deposited. When the power of X target is greater than 86.2 W, there is a problem that cracks are generated due to too high energy applied to X target.

For example, when the volumes (mol/cm³) per mole are calculated using the physical properties (density, atomic weight) of the respective materials (W and X) and divided by the thickness to deposit to a specific thickness, the mole values of the respective materials (W and X) are calculated by calculating a deposited mole value, and then fixing the thickness of an entire W-X alloy thin film and adjusting the thicknesses of the respective materials (W and X). The composition of the W-X alloy thin film (at%) may be determined using the calculated mole values.

Assuming that the W target and X target power are in direct proportion to the deposition power and deposition rate of each of the targets, deposition may be performed with power at which the deposition time of both the materials are the same, using a deposition rate of 50 W (2.47 W/cm²).

An initial vacuum degree of a sputtering chamber may be 5×10⁻⁹ Torr. When 39 sccm of argon is flowed into the sputtering chamber, a working pressure may be 1.4 mTorr.

Accordingly, the content of X included in the W-X alloy may be 0.1 at% to 46.4 at%. For example, when a tungsten (W)-titanium (Ti) alloy is used as a W-X alloy, a composition ratio (x, where x is a real number) of titanium in which PMA is expressed may satisfy 0.1 at% ≤ x ≤46.4 at% when a heat treatment temperature is 300 °C.

The step of forming a spin-orbit active layer on the substrate may further include a step of patterning the W-X alloy thin film in a cross shape.

The W-X alloy thin film may be patterned in a cross shape by performing photolithography and etching.

The method of fabricating a spin-orbit torque-based magnetic tunnel junction according to an embodiment of the present disclosure includes a step (S120) of forming a magnetization-free layer on the spin-orbit active layer, a step (S130) of forming a tunnel barrier layer on the magnetization-free layer, and a step (S140) of forming a magnetization-pinned layer on the tunnel barrier layer.

Each of the magnetization-free layer, the tunnel barrier layer and the magnetization-pinned layer may be formed by physical vapor deposition (PVD) including sputtering, molecular beam epitaxy (MBE), pulsed laser deposition (PLD), atomic layer deposition (ALD), e-beam epitaxy, chemical vapor deposition (CVD), a derived CVD process such as low-pressure CVD (LPCVD), ultrahigh vacuum CVD (UHVCVD) or reduced pressure CVD (RPCVD), electroplating, or any combination thereof.

According to an embodiment, the method of fabricating a spin-orbit torque-based magnetic tunnel junction according to an embodiment of the present disclosure may include, after the step (S140) of forming a pinned layer on the tunnel barrier layer, a step of forming a capping layer on the magnetization-pinned layer.

The capping layer may be formed by physical vapor deposition (PVD) including sputtering, molecular beam epitaxy (MBE), pulsed laser deposition (PLD), atomic layer deposition (ALD), e-beam epitaxy, chemical vapor deposition (CVD), a derived CVD process such as low-pressure CVD (LPCVD), ultrahigh vacuum CVD (UHVCVD) or reduced pressure CVD (RPCVD), electroplating, coating or any combination thereof.

The method of fabricating a spin-orbit torque-based magnetic tunnel junction according to an embodiment of the present disclosure includes the step (S 150) of thermally treating the magnetization-free layer and the magnetization-pinned layer to express PMA.

By the method of fabricating a spin-orbit torque-based magnetic tunnel junction according to an embodiment of the present disclosure, the spin torque efficiency may increase and the magnitude of a uniaxial anisotropic magnetic field may be decreased as the heat treatment temperature is elevated, so that switching current may be decreased. In addition, when the heat treatment temperature is elevated, an X (e.g., titanium) atom partially present as an impurity inside tungsten is melted into the tungsten structure to be structurally stabilized while forming an intermetallic compound, so that specific resistance may be decreased.

A heat treatment temperature at which PMA is expressed may be 300 °C.

Since a Back End Of Line (BEOL) process included in a semiconductor device process includes heat treatment at 300 °C to 400 °C, it is essential to develop an element capable of maintaining magnetic properties also at the temperature.

Accordingly, since the method of fabricating the spin-orbit torque-based magnetic tunnel junction having a CoFeB/MgO (free layer/tunnel barrier layer) structure according to an embodiment of the present disclosure should include thermally treating at least 250 °C to 300 °C for PMA expression such that the crystallization of CoFeB (free layer) proceeds, heat treatment should be performed at 300 °C or more. When the heat treatment temperature is higher than 500 °C, the temperature is outside a temperature range in which CoFeB (free layer) utilized as a magnetic layer can withstand, so that the properties of the magnetic layer are lost.

A tungsten (W) and titanium (Ti) alloy thin film (hereinafter referred to as a tungsten-titanium alloy layer) is used as a spin torque active layer that provides in-plane current by contacting the magnetization-free layer, thereby maintaining PMA and increasing the spin-orbit torque effect of SOT-MRAM at low resistivity.

### <Examples>

In the present disclosure, it was observed through theoretical calculations and experimental results that when a tungsten-titanium alloy layer was used, an increased SOT efficiency was achieved compared to a device using a single W layer.

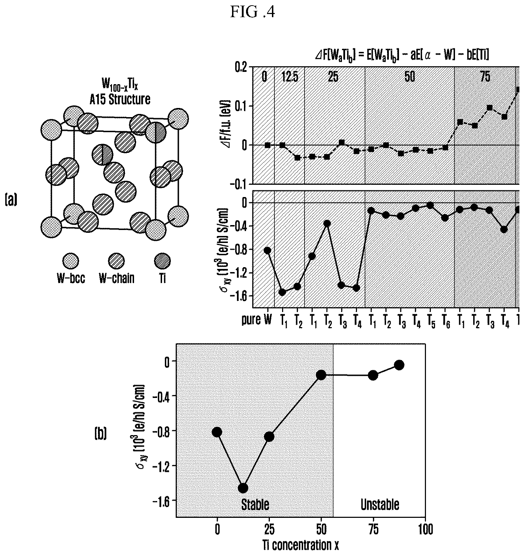

FIG. 4 illustrates results of the phase stability and spin Hall conductivity values for each W-Ti composition obtained by first-principle energy band calculation.

When the composition of Ti was 12.5 at%, the highest spin Hall conductivity of -1461 S/cm was observed.

To manufacture the spin-orbit torque-based magnetic tunnel junction 1 of the present disclosure, direct current (dc) magnetron sputtering was used when laminating a metal layer, and alternating current (ac) magnetron sputtering was used when laminating an insulator. Each base pressure was 5 x10⁻⁹ Torr or less, and deposition was performed in an argon (Ar) atmosphere. The thickness of each layer was controlled by adjusting a deposition time and a sputtering power.

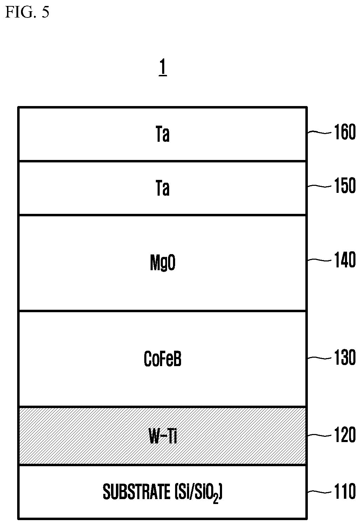

FIG. 5 illustrates a sectional view of a structure for measuring the spin-orbit torque efficiency of the spin-orbit torque-based magnetic tunnel junction according to an embodiment of the present disclosure.

As shown in FIG. 5, the structure of the spin-orbit torque-based magnetic tunnel junction 1 includes a Si/SiO₂ substrate/W-Ti 5/CoFeB 0.9/MgO 1/Ta 2 (thickness unit: nanometer, nm). Here, Si means a substrate, the SiO₂ layer is a natural oxide layer formed on the substrate and is amorphous. The W-Ti layer is an electrode layer, and W-Ti stands for tungsten-titanium alloy. The tungsten-titanium alloy was formed by sputtering a tungsten (W) target and a titanium (Ti) target at the same time. The tungsten target and titanium target were sputtered by DC magnetron sputtering. The composition of the tungsten-based alloy thin film was controlled by controlling the sputtering power of respective elements simultaneously sputtered in a state in which the flow rate of argon gas was fixed. The size of the target used to produce the tungsten-titanium alloy thin film was 2 inches in diameter. The CoFeB layer is a magnetic-free layer, and the composition of the sputtering target is Co₄₀Fe₄₀B₂₀ (at%). The MgO layer is an insulating layer, and the Ta layer is a capping layer. After the thin film deposition, heat treatment was performed at 300 °C for 1 hour. The base pressure during the heat treatment was 10⁻⁶ Torr, and an external magnetic field of 6 kOe was applied in a direction perpendicular to the thin film during the heat treatment.

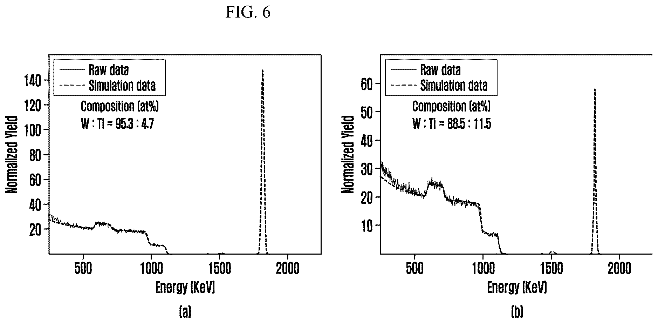

FIG. 6 is a graph illustrating the quantitative analysis of the composition of Ti by Rutherford Backscattering Spectrometry (RBS).

In the W-Ti/CoFeB/MgO/Ta structure, the composition of Ti was quantitatively confirmed by Rutherford Backscattering Spectrometry (RBS) as shown in FIG. 6.

To confirm the spin Hall angle for the specimen that maintained the PMA after heat treatment at 300 °C, a cross-shaped Hall bar having a size of 5 × 35 *µ*m² was fabricated by a photolithography process, and the CoFeB/MgO/Ta layer was fabricated in the form of an island measuring 6 *µ*m in diameter.

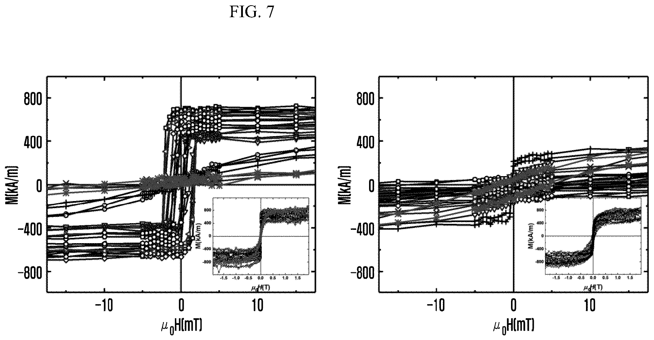

FIG. 7 illustrates magnetic hysteresis loops (VSM), measured by a vibrating sample magnetometer, for thin films after a heat treatment at 300 °C.

FIG. 7A illustrates magnetic hysteresis loops dependent upon the content (11.5 at% to 20.8 at%) of titanium in a spin-orbit torque active layer when a magnetic field was applied in a direction (out-of-plane) perpendicular to the thin film plane to the spin-orbit torque-based magnetic tunnel junction (hereinafter referred to as the W-Ti/CoFeB/MgO/Ta structure according to Example 1) according to an embodiment of the present disclosure, illustrated in FIG. 5, heat-treated at 300 °C for 1 hour. FIG. 7B illustrates magnetic hysteresis loops dependent upon the content (11.5 at% to 20.8 at%) of titanium in the spin-orbit torque active layer when a magnetic field was applied in an in-plane direction of the thin film.

As a result, when the thickness of the tungsten-titanium alloy in the W-Ti/CoFeB/MgO/Ta structure was fixed to 5 nm, PMA was expressed from 0 at% to 46.4 at% of the titanium composition.

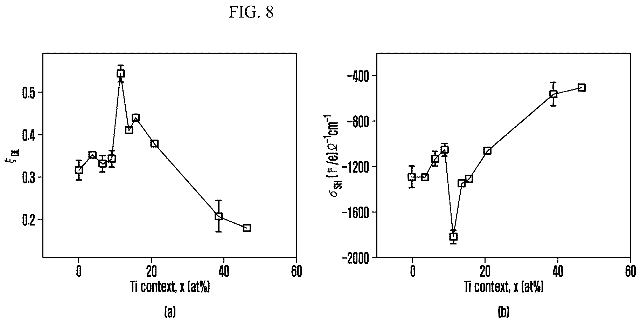

FIG. 8 illustrates the spin Hall angle of a Hall bar-shaped device measured using a harmonics measurement method in the composition range of a tungsten-titanium alloy layer having PMA after heat-treating a W-Ti 5/CoFeB 0.9/MgO 1.0/ Ta 2 (unit: nm) structure at 300 °C; and the spin Hall conductivity converted from the spin Hall angle.

FIG. 8A illustrates the spin Hall angle dependent upon the content of titanium, and FIG. 8B illustrates the spin Hall conductivity dependent upon the content of titanium.

As shown in FIG. 8A, it was confirmed that, when the tungsten-titanium alloy layer was heat-treated at 300 °C, the spin Hall angle in the titanium composition of 11.5 to 20.8 at% increased, compared to the case (30%) where the single tungsten layer was used. In particular, when the composition of Ti was 11.5 at%, a spin Hall angle of 0.55 which increased by about 83% compared to the single tungsten layer was observed.

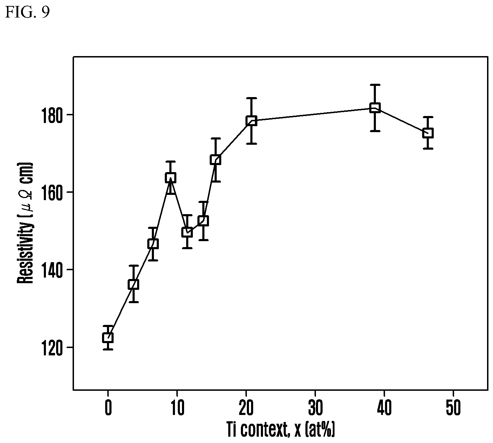

FIG. 9 illustrates the resistivity of an alloy layer measured using a four-point probe in the composition range of a tungsten-titanium alloy layer having PMA after heat-treating a W-Ti 5/CoFeB 0.9/MgO 1.0/ Ta 2(unit: nm) structure at 300 °C.

FIG. 9 illustrates the resistivity of W-Ti calculated by performing parallel resistance calculations on the electrode layer W-Ti and the magnetic-free layer CoFeB (ρ = 170 µΩ·cm) based on the assumption that no current flows through a tunnel barrier layer (MgO) 140, a magnetization-pinned layer (Ta) 150 and a capping layer (Ta) 160 when current is passed through the structure.

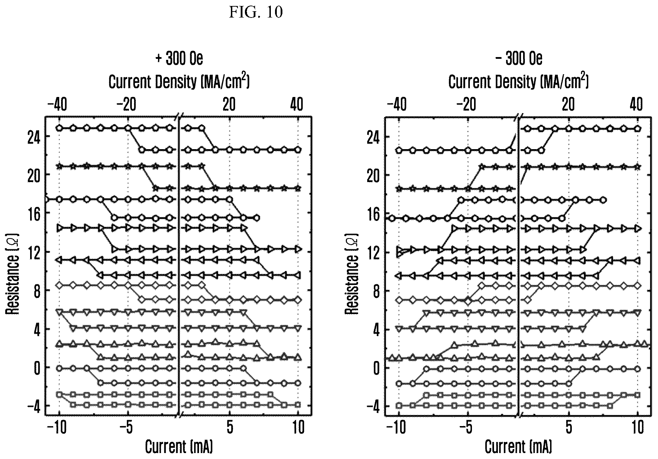

FIG. 10 illustrates the spin-orbit torque switching characteristics dependent upon the composition of a tungsten-titanium alloy layer when an external magnetic field of ±300 Oe is applied to a specimen having a W-Ti 5/CoFeB 0.9/MgO 1.0/Ta 2 (unit: nm) structure that has been heat-treated at 300 °C.

From FIG. 10, it was confirmed that, in all the compositions of titanium, switching occurred at a current smaller than that of the single tungsten layer.

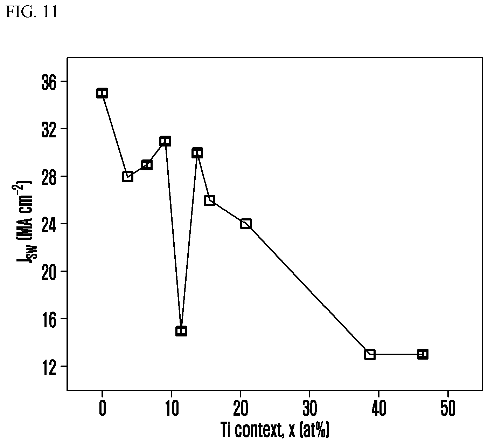

FIG. 11 illustrates a change in switching current density when an external magnetic field of ±300 Oe is applied to a specimen having a W-Ti 5/CoFeB 0.9/MgO 1.0/Ta 2 (unit: nm) structure that has been heat-treated at 300 °C.

As shown in FIG. 11, it was confirmed that the switching current is decreased with increasing composition of titanium. In the specimens heat-treated at 300 °C, the switching current density was 35.5 MA/cm² when titanium was absent, and, when the composition of Ti was 11.5 at%, the switching current density was decreased to 15.0 MA/cm².

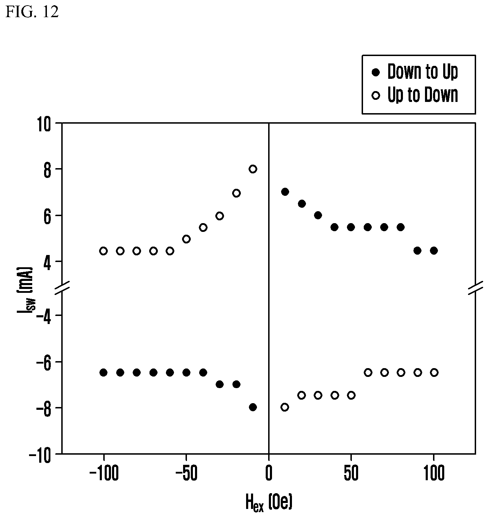

FIG. 12 illustrates switching current (current density) measurement results measured while changing the magnitude of an external magnetic field after a specimen having a W-Ti 5/CoFeB 0.9/MgO 1.0/Ta 2 (unit: nm) structure and containing titanium, which formed a tungsten-titanium alloy layer, in a content of 11.5 at% was heat-treated at 300 °C.

As shown in FIG. 12, it was confirmed that the value of the switching current required for magnetization reversal decreased depending upon an external magnetic field applied while increasing the magnitude from 10 Oe to 100 Oe, and the spin-orbit torque switching phenomenon was observed under all the applied external magnetic fields.

Experiments were carried out to measure the operating temperature and external magnetic field range of a device to which the spin-orbit torque-based magnetic tunnel junction according to an embodiment of the present disclosure is applied.

### [Table 1]

**<Table 1, source: J. M. Iwata-Harms et al., Scientific Reports, 8:14409 (2018)>**

| Application | Operating Temperatures | Data Retention | | Thermal Budget for Manufacturing |
|---|---|---|---|---|
| | | Operation | Solder Reflow | |
| Commercial | 0 to 70°C | >10 years at the maximum operating temperature | 90 seconds at 260°C | 400°C, up to 5 hours |
| Industrial | -40 to 85°C | | | |
| Automotive | 40 to 150 °C | | | |
| Military | -55 to 125°C | | | |

### [Table 2]

**<Table 2, source: Automotive semiconductor standards determined by Automotive Electronic Council >**

| GRADE | TEMPERATURE RANGE | | PASSIVE COMPONENT TYPE Maximum capability unless otherwise specified and qualified | TYPICAL/EXAMPLE APPLICATION |
|---|---|---|---|---|
| | MINIMUM | MAXIMUM | | |
| 0 | -50°C | +150°C | Flat chip ceramic resistors, X8R ceramic capacitors | All automotive |
| 1 | -40°C | +125°C | Capacitor Networks, Resistors, Inductors, Transformers, Thermistors, Resonators, Crystals and Varistors, all other ceramic and tantalum capacitors | Most underhood |
| 2 | -40°C | + 105°C | Aluminum Electrolytic capacitors | Passenger compartment hot spots |
| 3 | -40°C | +85°C | Film capacitors, Ferrites, R/R-C Networks and Trimmer capacitors | Most passenger compartment |
| 4 | 0°C | +70°C | | Non-automotive |

Table 1 shows the operating temperature ranges of applications in the commercial, industrial, automotive, and military fields, and Table 2 shows the grades of automotive semiconductors according to their operating temperature ranges.

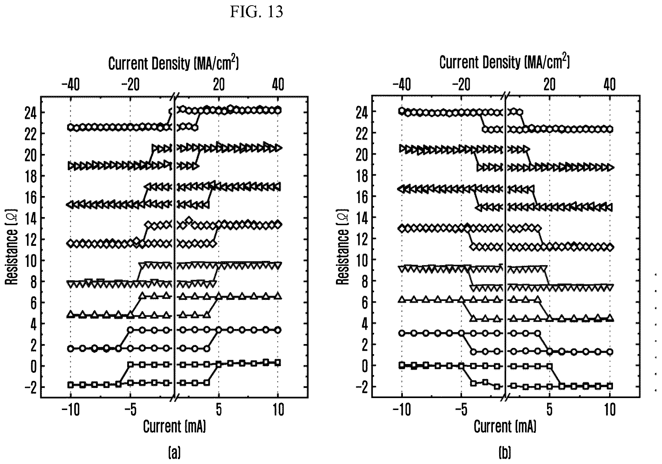

FIG. 13 illustrates a change in the switching current density of one device (Ti: 11.5%), to which a spin-orbit torque-based magnetic tunnel junction is applied, according to the conversion of an operating temperature.

As shown in FIG. 13, to verify the operating temperature resilience, the switching current density and resistance of the device with the spin-orbit torque-based magnetic tunnel junction applied thereto were measured while increasing the temperature by 25 °C in a range of -55 °C to 150 °C.

As a measurement result, It was confirmed that the switching current density decreases as the temperature increases due to thermal fluctuation. At the same time, it was confirmed that the device operates normally at high and low temperatures. The temperatures correspond to the Auto-Grade-0 (automotive) in Table 2, and it was confirmed that the device to which the spin-orbit torque-based magnetic tunnel junction structure of the present disclosure is applied can be sufficiently used for automotive semiconductors. As a result, it was confirmed that the device to which the spin-orbit torque-based magnetic tunnel junction structure of the present disclosure was applied corresponds to all grades of Table 2 below, and thus, can be applied to applications in all temperature ranges.

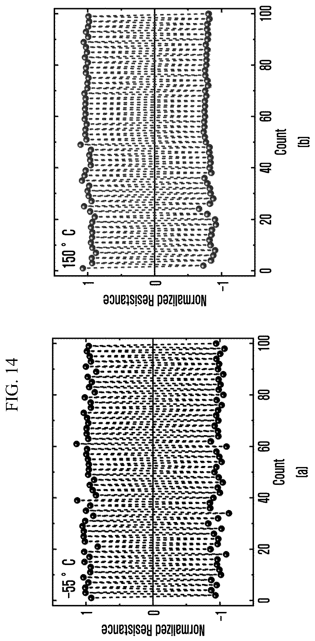

FIG. 14 illustrates a normalized resistance change in the device, to which the spin-orbit torque-based magnetic tunnel junction was applied, measured by switching 100 times at extreme temperatures of (a) -55 °C and (b) 150 °C to verify the operating temperature stability of the device.

As shown in FIG. 14, the normalized resistance change of the device with the spin-orbit torque-based magnetic tunnel junction was confirmed to be uniform within a certain range by performing 100 switching cycles at extreme temperatures of (a) -55 °C and (b) 150 °C. Accordingly, it was confirmed that the device to which the spin-orbit torque-based magnetic tunnel junction structure of the present disclosure was applied had operating temperature stability even at extreme temperatures.

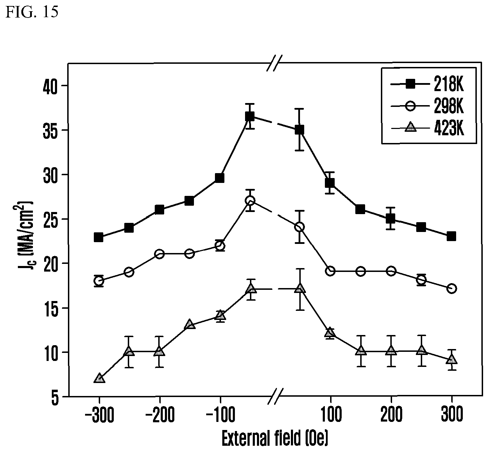

FIG. 15 illustrates a change in the current density (switching current density, Jc) of the device, to which the spin-orbit torque-based magnetic tunnel junction was applied, dependent upon an operating temperature and an external magnetic field.

As shown in FIG. 15, it was confirmed that the switching current density of the device to which the spin-orbit torque-based magnetic tunnel junction of the present disclosure was applied was decreased with increasing external magnetic field and temperature. This result was consistent with prior art.

In conclusion, referring to Tables 1 and 2 and FIGS. 13 to 14, it was confirmed that the device to which the spin-orbit torque-based magnetic tunnel junction of the present disclosure was applied had operating stability depending upon the temperature in a range of -55 °C to 150 °C. Accordingly, the device to which the spin-orbit torque-based magnetic tunnel junction of the present disclosure was applied has temperature-dependent operating stability in a range of -55 °C to 150 °C and can be applied to various industrial applications.

In accordance with an embodiment of the present disclosure, a spin-orbit torque-based magnetic tunnel junction enabling spin-orbit torque switching and exhibiting high spin-orbit torque efficiency at low resistivity by using a W-X alloy thin film having large spin-orbit coupling as a spin-orbit torque active layer; and a method of manufacturing the spin-orbit torque-based magnetic tunnel junction can be provided.

In accordance with an embodiment of the present disclosure, a spin-orbit torque-based magnetic tunnel junction capable of controlling a switching current by adjusting the composition of X in the W-X alloy, and a method of manufacturing the spin-orbit torque-based magnetic tunnel junction can be provided.

In accordance with an embodiment of the present disclosure, a spin-orbit torque-based magnetic tunnel junction capable of maintaining the perpendicular magnetic anisotropy (PMA) in various heat treatment temperature ranges by using a tungsten-titanium alloy as a spin-orbit torque active layer, and a method of manufacturing the spin-orbit torque-based magnetic tunnel junction can be provided.

In accordance with an embodiment of the present disclosure, an SOT device including the tungsten-titanium alloy layer shows increased SOT efficiency, compared to a device including an existing single W layer and, at the same time, maintains low resistivity and PMA.

It will be understood that effects of the present disclosure are not limited to those referred below and other non-referred effects will be clearly understood by those skilled in the art from disclosures below.

Although the present disclosure has been described with reference to limited embodiments and drawings, it should be understood by those skilled in the art that various changes and modifications may be made therein. For example, the described techniques may be performed in a different order than the described methods, and/or components of the described systems, structures, devices, circuits, etc., may be combined in a manner that is different from the described method, or appropriate results may be achieved even if replaced by other components or equivalents.

Therefore, other embodiments, other examples, and equivalents to the claims are within the scope of the following claims.

## Claims

1. A spin-orbit torque-based magnetic tunnel junction, comprising:
a spin-orbit torque active layer formed on a substrate;
a magnetization-free layer formed on the spin-orbit torque active layer;
a tunnel barrier layer formed on the magnetization-free layer; and
a magnetization-pinned layer formed on the tunnel barrier layer,
wherein the spin-orbit torque active layer is a W-X alloy (where W is tungsten, and X comprises at least one of group IV semiconductors and group III-V semiconductors).

2. The spin-orbit torque-based magnetic tunnel junction according to claim 1, wherein the spin-orbit torque active layer is an electrode that provides an in-plane current by contacting the magnetization-free layer.

3. The spin-orbit torque-based magnetic tunnel junction according to claim 1 or 2, wherein a switching current is decreased with increasing composition content of X contained in the W-X alloy.

4. The spin-orbit torque-based magnetic tunnel junction according to one of claims 1 to 3, wherein the W-X alloy is a tungsten-titanium (W-Ti) alloy in which a composition content of titanium is 11.5 at% to 20.8 at%.

5. The spin-orbit torque-based magnetic tunnel junction according to one of claims 1 to 4, wherein a heat treatment temperature at which perpendicular magnetic anisotropy is expressed is 300 °C.

6. The spin-orbit torque-based magnetic tunnel junction according to one of claims 1 to 5, wherein a composition content of X contained in the W-X alloy is controlled depending upon a heat treatment temperature at which perpendicular magnetic anisotropy is expressed.

7. The spin-orbit torque-based magnetic tunnel junction according to one of claims 1 to 6, wherein the spin-orbit torque active layer has a cross shape when viewed in a planar plane, and the magnetization-free layer, the tunnel barrier layer and the magnetization-pinned layer are arranged in an island shape at a center of the cross-shaped spin-orbit torque active layer.

8. The spin-orbit torque-based magnetic tunnel junction according to one of claims 1 to 7, wherein a surface of the substrate in contact with the spin-orbit torque active layer comprises a natural oxide layer.

9. The spin-orbit torque-based magnetic tunnel junction according to one of claims 1 to 8, wherein a lower side of the spin-orbit torque active layer further comprises a buffer layer.

10. The spin-orbit torque-based magnetic tunnel junction according to one of claims 1 to 9, wherein a capping layer is further comprised on the magnetization-pinned layer.
